# EUROPÄISCHE PATENTSCHRIFT

(11) **EP 1 318 709 B1**
(45) Veröffentlichungstag und Bekanntmachung des Hinweises auf die Patenterteilung: **24.03.2004**
(21) Anmeldenummer: 01129104.4
(22) Anmeldetag: 07.12.2001
(51) Int. Cl.: H05K 7/14, H05K 9/00

(54) **Anordnung mit einer Trägerkarte und mindestens einer Tochterkarte**
Arrangement with a support board and at least one daughter board
Appareil muni d'une carte support et au moins une carte-fille

(43) Veröffentlichungstag der Anmeldung: 11.06.2003
(73) Patentinhaber: Tektronix Berlin GmbH & Co. KG, 13629 Berlin (DE)
(72) Erfinder: Klimke, Jens, 14612 Falkensee (DE); Ness, Christian, 13189 Berlin (DE)
(74) Vertreter: Schurack, Eduard F.

(56) Entgegenhaltungen:
- EP-A- 0 317 464
- FR-A- 2 290 127
- US-A- 4 694 380

## Beschreibung

Die vorliegende Erfindung betrifft eine Anordnung mit einer Trägerkarte und mindestens einer Tochterkarte, insbesondere eine derartige Anordnung bei der die Trägerkarte mindestens ein erstes Befestigungsmittel zur Befestigung der Trägerkarte in einem Mainframe aufweist, wobei die Frontseite der Anordnung, die nach Einbau der Anordnung in einem Mainframe von außen zugänglich bleibt, eine genormte Breite aufweist, wobei die Tochterkarte mit mindestens einem zweiten Befestigungsmittel mit der Trägerkarte derart verbunden ist, daß ein elektrisch leitfähiges Frontelement der Tochterkarte zumindest einen Abschnitt der Frontseite der Anordnung bildet.

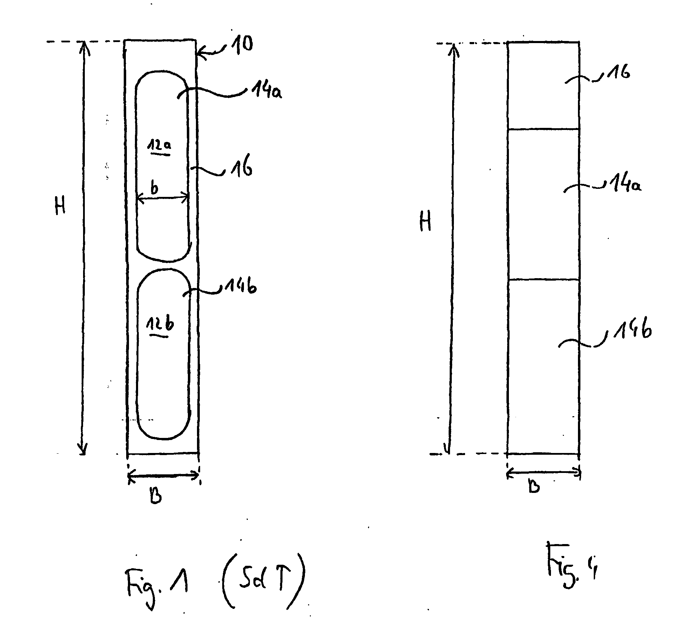

Das der Erfindung zugrundeliegende Problem wird nachfolgend im Zusammenhang mit Figur 1 dargestellt. Die Figur 1 zeigt in schematischer Darstellung eine aus dem Stand der Technik bekannte Trägerkarte 10, auf der zwei Tochterkarten 12a, 12b angeordnet sind, von denen jedoch in der Darstellung von Figur 1 lediglich deren elektrisch leitfähige Frontelemente 14a und 14b zu sehen sind. Die Anordnung aus Trägerkarte 10 und Tochterkarten 12a, 12b weist eine genormte Breite B und eine genormte Höhe H auf. Diese können beispielsweise der Norm IEEE 1101 entsprechen, die für das CPCI-Bussystem beziehungsweise für den VME-Bus ausgelegt sind.

Der Nachteil dieser aus dem Stand der Technik bekannten Anordnung besteht darin, daß Anschlußelemente auf den Tochterkarten 12a, 12b lediglich eine Breite aufweisen dürfen, die durch die Breite b des Frontelements 14a, 14b einer Tochterkarte begrenzt ist. Vorliegend kann bereits die Anordnung eines herkömmlichen BNC-Anschlusses Probleme bereiten. Ein weiteres Problem ergibt sich dadurch, daß die Frontelemente 14a, 14b mit der Frontseite 16 der Trägerkarte 10 elektrisch leitfähig verbunden sein müssen. Dies stellt einerseits hohe Anforderungen an die Qualität der Fertigung, sowohl des Ausschnitts des Frontelements 16 der Trägerkarte 10 als auch der Frontelemente 14a, 14b der Tochterkarten 12a, 12b. Bekannt ist, in die Lücke zwischen dem Frontelement 14a, 14b einer Tochterkarte 12a, 12b und Frontelement 16 der Trägerkarte 10 metallisch leitfähige Dichtungen einzubringen. Diese sind jedoch entweder gut leitend oder flexibel. Ein gut leitender und dichter Übergang zwischen den Frontelementen 14a, 14b der Tochterkarten 12a, 12b und dem Frontelement 16 der Trägerkarte 10 ist daher nur schwierig zu realisieren. Bei einer schlechten Abdichtung ergibt sich darüber hinaus ein EMV-Problem dadurch, daß elektromagnetische Strahlung durch die Lücken zwischen den Frontelementen der Tochterkarte und dem der Trägerkarte austreten und dadurch Störungen verursachen kann.

Die Aufgabe der vorliegenden Erfindung besteht deshalb darin, die eingangs genannte Anordnung derart weiterzubilden, daß die Verwendung möglichst breiter Anschlußelemente auf einer Tochterkarte ermöglicht wird und daß das EMV-Problem reduziert ist.

Diese Aufgabe wird erfindungsgemäß dadurch gelöst, daß bei der eingangs genannten Anordnung das Frontelement der Tochterkarte in zumindest einem Abschnitt die genormte Breite aufweist.

Der Erfindung liegt die Erkenntnis zugrunde, daß die oben genannten Probleme dadurch vermieden werden können, wenn das Frontelement der Tochterkarte selbst über einen gewissen Höhenabschnitt das Frontelement der Anordnung bildet. Dadurch kann das Frontelement einer Tochterkarte so breit ausgeführt werden, wie dies die Norm erlaubt, wodurch für die Tochterkarte die selben Anschlüsse gewählt werden können wie für die Trägerkarte. Dadurch, daß die genormte Breite sehr viel geringer ist als die beim Stand der Technik in Richtung der Höhe der Anordnung verlaufenden Lücken, ist das EMV-Problem deutlich reduziert.

Aufgrund dessen, daß das Frontelement einer Tochterkarte nicht mehr in das Frontelement der Trägerkarte eingepaßt werden muß, insbesondere die Kanten der Tochterkarten gerade verlaufen können, ergibt sich eine wesentlich einfachere Herstellung, wodurch die Herstellungskosten deutlich reduziert werden.

Bei einer besonders bevorzugten Ausführungsform ist das Frontelement der Tochterkarte von Durchgangsöffnungen und/oder EMV-Flanschen abgesehen, von einheitlicher Dicke. Die Herstellung von Frontelementen der Tochterkarte mit einheitlicher Dicke ist besonders einfach und daher kostengünstig.

Bevorzugt ist das Frontelement der Tochterkarte über ein elektrisch leitfähiges Kopplungselement mit einem Abschnitt der Trägerkarte verbunden, der einen Abschnitt der Frontseite der Anordnung bildet. Ein derartiges Kopplungselement läßt sich großzügig ausbilden, so daß ein guter elektrischer Kontakt zwischen dem Frontelement der Tochterkarte und dem Abschnitt der Trägerkarte, der einen Abschnitt der Frontseite der Anordnung bildet, hergestellt werden kann. Insbesondere kann hier beispielsweise die Rückseite des Frontelements der Tochterkarte verwendet werden, um diese über eine gewisse Fläche mit dem Kopplungselement in Kontakt zu bringen, während im Stand der Technik lediglich die aufgrund der Dicke der Frontelemente sehr geringen Kontaktflächen verwendet wurden.

Bevorzugt ist das Frontelement der Tochterkarte über mindestens ein elektrisch leitendes Kopplungselement mit dem Frontelement mindestens einer weiteren Tochterkarte verbunden, wobei die mindestens eine weitere Tochterkarte auch einen Abschnitt der Frontseite der Anordnung bildet. Bei dieser Variante kann ein Kopplungselement für die Realisierung einer elektrisch leitfähigen Verbindung zwischen mehreren Tochterkarten und einem Abschnitt der Frontseite der Anordnung verwendet werden, der von der Trägerkarte gebildet wird.

Das Kopplungselement kann U-Form oder Blockform aufweisen. Dabei kann eine Seite der U-Form oder des Blocks mit der Trägerkarte, eine andere Seite der U-Form oder des Blocks mit mindestens einem elektrisch leitfähigen Frontelement einer Tochterkarte verbunden sein. Das Kopplungselement dient bei einer derartigen Ausbildung nicht nur zur Herstellung einer leitfähigen Verbindung, sondern auch zur stabilen Montage einer Tochterkarte auf der Anordnung.

Die Anordnung kann insbesondere einem mechanischen Aufbau gemäß der Norm IEEE 1101 genügen.

Die an der Frontseite der Anordnung zu liegen kommende, vom Kopplungsmittel abgekehrte Seite der Tochterkarte kann über ein drittes Befestigungsmittel mit der Trägerkarte verbunden sein. Das dritte Befestigungsmittel kann als Bolzen ausgeführt sein und stellt daher eine einfache Möglichkeit bereit, die Tochterkarte zuverlässig mit der Trägerkarte zu verbinden.

Bei einer bevorzugten Ausführungsform weist das Frontelement der mindestens einen Tochterkarte über seine gesamte Länge die genormte Breite auf. Dadurch kann das Frontelement rechteckig ausgeführt werden, was in besonders einfachen Herstellungs- und Montagekosten resultiert. Bei dieser Ausführungsform bildet dann jedes Frontelement einer Tochterkarte einen Höhenabschnitt der Frontseite der Anordnung.

Weitere vorteilhafte Ausführungsformen der Erfindung sind den Unteransprüchen zu entnehmen.

Im Nachfolgenden wird nunmehr ein Ausführungsbeispiel der Erfindung mit Bezug auf die beigefügten Zeichnungen näher beschrieben.

Es stellen dar:
- Figur 1: eine aus dem Stand der Technik bekannte Anordnung einer Trägerkarte mit zwei Tochterkarten;
- Figur 2: eine erfindungsgemäße Anordnung, bei der eine Tochterkarte bereits mit der Trägerkarte verbunden ist, eine weitere Tochterkarte noch nicht;
- Figur 3: die erfindungsgemäße Anordnung von Figur 2, bei der beide Tochterkarten mit der Trägerkarte verbunden sind; und
- Figur 4: eine erfindungsgemäße Anordnung gemäß einem zweiten Ausführungsbeispiel.

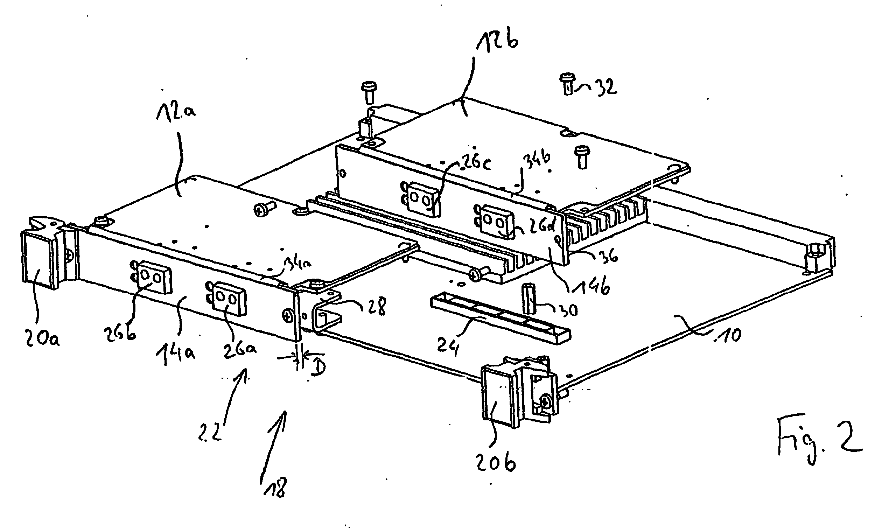

In den Figuren werden für gleiche oder gleichwirkende Elemente durchweg gleiche Bezugszeichen verwendet. Figur 2 zeigt eine Anordnung 18, die eine Trägerkarte 10 und zwei Tochterkarten 12a, 12b umfaßt. Die Anordnung kann mittels Befestigungselementen 20a, 20b in einem Mainframe befestigt werden. Jede Tochterkarte 12a, 12b weist ein Frontelement 14a, 14b auf, das im montierten Zustand der Tochterkarte 12a, 12b einen Teil der Frontseite 22 der Anordnung bildet. Die Trägerkarte weist Befestigungsmittel 24 auf, um die Tochterkarten 14a, 14b mechanisch und elektrisch leitend mit der Trägerkarte 10 zu verbinden. Auf den Frontkarten 14a, 14b der Tochterkarten 12a, 12b sind beispielhaft Anschlüsse 26a bis d eingezeichnet.

Ein U-förmiges, elektrisch leitfähiges Kopplungselement 28 dient zur Herstellung leitfähiger Verbindungen der Tochterkarten 12a, 12b und der Trägerkarte 10. Vorliegend sind weiterhin die Frontelemente 14a, 14b der Tochterkarten 12a, 12b leitenfähig über das Kopplungselement 28 miteinander verbunden. Das Kopplungselement 28 kann jede andere geeignete Form, insbesondere Blockform aufweisen. Ein Bolzen 30 und eine Schraube 32 dienen dazu, die Rückseite der Tochterkarte 12b stabil mit der Trägerkarte 10 zu verbinden. Mit Ausnahme von EMV-Flanschen 34a, 34b und Durchgangsöffnungen, wovon beispielhaft eine Durchgangsöffnung mit der Bezugszahl 36 bezeichnet ist, weisen die Frontelemente 14a, 14b der Tochterkarten 12a, 12b in ihrer gesamten Höhe eine einheitliche Dicke D auf.

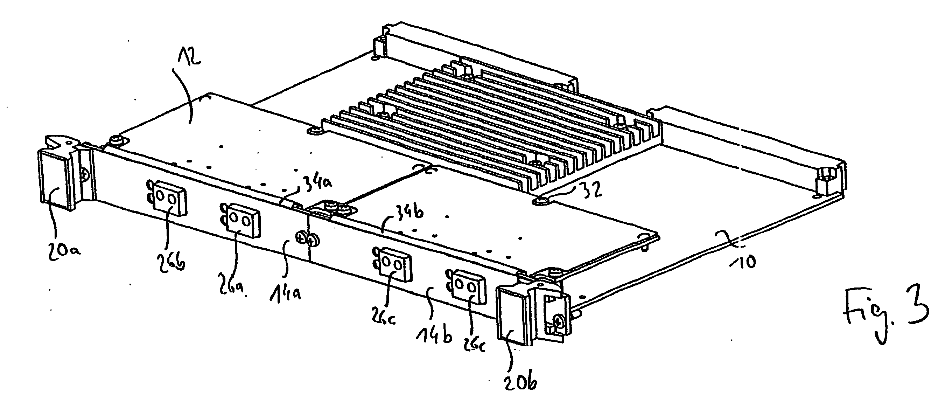

Figur 3 zeigt die in Figur 2 dargestellte Anordnung, nachdem auch die Tochterkarte 12b mit der Trägerkarte 10 verbunden wurde. In dem dargestellten Ausführungsbeispiel

Wie in Figur 4 dargestellt, kann ein Teil der Frontseite 22 der Anordnung 18 von einem Frontelement 16 der Trägerkarte 10 selbst gebildet sein. Dieser Abschnitt 16 weist bevorzugt ebenfalls über seine gesamte Länge die genormte Breite B auf. Mit diesem Abschnitt können, ebenfalls unter Verwendung von Kopplungselementen 28, eine oder mehrere Tochterkarten verbunden sein. Der oberste Abschnitt der Frontseite der Anordnung ist in dem in Fig. 4 dargestellten Ausführungsbeispiel somit von dem Frontelement 16 der Trägerkarte 10 gebildet, während die beiden sich daran anschließenden Abschnitte von den Frontelementen 14a, 14b der Tochterkarten gebildet werden. Selbstverständlich läßt sich die Erfindung auch mit mehreren Tochterkarten und mehreren Frontelementen der Trägerkarte realisieren.

## Patentansprüche

1. Anordnung (18) mit einer Trägerkarte (10) und mindestens einer Tochterkarte (12a, 12b), wobei die Trägerkarte (10) mindestens ein erstes Befestigungsmittel (20a; 20b) zur Befestigung der Trägerkarte (10) in einem Mainframe aufweist, wobei die Frontseite (22) der Anordnung (18), die nach Einbau der Anordnung (18) in einen Mainframe von außen zugänglich bleibt, eine genormte Breite (B) aufweist, wobei die Tochterkarte (12a; 12b) mit mindestens einem zweiten Befestigungsmittel (24) mit der Trägerkarte (10) derart verbunden ist, daß ein elektrisch leitfähiges Frontelement (14a; 14b) der Tochterkarte (12a; 12b) zumindest einen Abschnitt der Frontseite (22) der Anordnung (18) bildet,
**dadurch gekennzeichnet,**
**daß** das Frontelement (14a; 14b) der Tochterkarte (12a; 12b) in zumindest einem Abschnitt die genormte Breite (B) aufweist.

2. Anordnung nach Anspruch 1,
**dadurch gekennzeichnet,**
**daß** das Frontelement (14a; 14b) der Tochterkarte (12a; 12b), von Durchgangsöffnungen (36) und/oder EMV-Flanschen (34a; 34b) abgesehen, von einheitlicher Dicke (D) ist.

3. Anordnung nach Anspruch 1 oder 2,
**dadurch gekennzeichnet,**
**daß** das Frontelement (14a; 14b) der Tochterkarte (12a; 12b) über ein elektrisch leitfähiges Kopplungselement (28) mit einem Abschnitt (16) der Trägerkarte (10) verbunden ist, der einen Abschnitt der Frontseite (22) der Anordnung (18) bildet.

4. Anordnung nach einem der vorhergehenden Ansprüche,
**dadurch gekennzeichnet,**
**daß** das Frontelement (14a) der Tochterkarte (12a) über mindestens ein elektrisch leitendes Kopplungselement (28) mit dem Frontelement (14b) mindestens einer weiteren Tochterkarte (12b) verbunden ist, wobei die mindestens eine weitere Tochterkarte (12b) auch einen Abschnitt der Frontseite (22) der Anordnung (18) bildet.

5. Anordnung nach einem Ansprüche 3 oder 4,
**dadurch gekennzeichnet,**
**daß** das Kopplungselement (28) U-Form oder Blockform aufweist.

6. Anordnung nach Anspruch 5,
**dadurch gekennzeichnet,**
**daß** eine Seite der U-Form oder des Blocks mit der Trägerkarte (10), eine andere Seite der U-Form oder des Blocks mit mindestens einem elektrisch leitfähigen Frontelement (14a; 14b) verbunden ist.

7. Anordnung nach einem der vorhergehenden Ansprüche,
**dadurch gekennzeichnet,**
**daß** die mindestens eine Tochterkarte (12a; 12b) mindestens einen Anschluß (26a; 26b; 26c; 26d) für Ein- und/oder Ausgangssignale aufweist.

8. Anordnung nach einem der vorhergehenden Ansprüche,
**dadurch gekennzeichnet,**
**daß** die Anordnung (18) einem mechanischen Aufbau gemäß der Norm IEEE 1101 genügt.

9. Anordnung nach einem der Ansprüche 4 bis 8,
**dadurch gekennzeichnet,**
**daß** die an der Frontseite (22) der Anordnung (18) zu liegen kommende, vom Kopplungsmittel (28) abgekehrte Seite der Tochterkarte (12a; 12b) über ein drittes Befestigungsmittel (30) mit der Trägerkarte (10) verbunden ist.

10. Anordnung nach einem der vorhergehenden Ansprüche,
**dadurch gekennzeichnet,**
**daß** das Frontelement (14a; 14b) der mindestens einen Tochterkarte (12a, 12b) über seine gesamte Länge die genormte Breite (B) aufweist.

11. Anordnung nach einem der vorhergehenden Ansprüche,
**dadurch gekennzeichnet,**
**daß** die Trägerkarte (10) Befestigungsmittel zur mechanischen und elektrisch leitfähigen Verbindung mit einem Mainframe aufweist.

## Claims

1. Assembly (18) including a support board (10) and at least one daughter board (12a, 12b), the support board (10) having at least a first fixing means (20a; 20b) for fixing the support board (10) in a mainframe, wherein the front side (22) of the assembly (18), which remains accessible from outside after installing the assembly (18) in a mainframe, has a standardized width (B), wherein the daughter board (12a; 12b) is connected by means of at least a second fixing means (24) to the support board (10) such that an electrically conductive front element (14a; 14b) of the daughter board (12a; 12b) constitutes at least one section of the front side (22) of the assembly (18),
**characterized in that**
the front element (14a; 14b) of the daughter board (12a; 12b) has the standardized width (B) in at least one section.

2. Assembly according to claim 1,
**characterized in that**
the front element (14a; 14b) of the daughter board (12a; 12b) has a uniform thickness (D) except for through openings (36) and or EMV flanges (34a; 34b).

3. Assembly according to claim 1 or 2,
**characterized in that**
the front element (14a; 14b) of the daughter board (12a; 12b) is connected through an electrically conductive coupling member (28) to a section (16) of the support board (10), which constitutes a section of the front side (22) of the assembly (18).

4. Assembly according to any one of the preceding claims,
**characterized in that**
the front element (14a) of the daughter board (12a) is connected to the front element (14b) of at least one further daughter board (12b) through at least one electrically conductive coupling member (28), the at least one further daughter board (12b) also constitutes a section of the front side (22) of the assembly (18).

5. Assembly according to any one of claims 3 or 4,
**characterized in that**
the coupling member (28) has a U-shape or block form.

6. Assembly according to claim 5,
**characterized in that**
one side of the U-shape or of the block is connected to the support board (10), another side of the U-shape or of the block is connected to at least one electrically conductive front element (14a; 14b).

7. Assembly according to any one of the preceding claims,
**characterized in that**
the at least one daughter board (12a; 12b) has at least one terminal (26a; 26b; 26c; 26d) for input and/or output signals.

8. Assembly according to any one of the preceding claims,
**characterized in that**
the assembly (18) conforms to a mechanical construction according to the standard IEEE 1101.

9. Assembly according to any one of claims 4 to 8,
**characterized in that**
the side of the daughter board (12a; 12b) facing away from the coupling means (28) and abutting the front side (22) of the assembly (18) is connected to the support board (10) through a third fixing means (30).

10. Assembly according to any one of the preceding claims,
**characterized in that**
the front element (14a; 14b) of the at least one daughter board (12a, 12b) has the standardized width (B) throughout its length.

11. Assembly according to any one of the preceding claims,
**characterized in that**
the support board (10) has fixing means for mechanical and electrically conductive connection to a mainframe.

## Revendications

1. Dispositif (18) comprenant une carte mère (10) et au moins une carte fille (12a,12b), la carte mère (10) étant munie d'au moins un premier moyen de fixation (20a,20b) prévu pour fixer la carte mère (10) à l'intérieur d'un ordinateur central (mainframe), la face frontale (22) du dispositif (18) restant accessible de l'extérieur après montage du dispositif (18) à l'intérieur d'un ordinateur central présentant une largeur normalisée (B), la carte fille (12a; 12b) étant reliée, par au moins un deuxième moyen de fixation (24), à la carte mère (10) de telle sorte qu'un élément frontal électriquement conducteur (14a; 14b) de la carte fille (12a; 12b) forme au moins une section de la face frontale (22) du dispositif (18),
**caractérisé en ce que**
l'élément frontal (14a; 14b) de la carte fille (12a; 12b) présente la largeur normalisée (B) au moins dans une section.

2. Dispositif selon la revendication 1,
**caractérisé en ce que**
l'élément frontal (14a; 14b) de la carte fille (12a; 12b) a une épaisseur uniforme (D), à l'exception des passages (36) et/ou des brides de type CEM (34a; 34b).

3. Dispositif selon la revendication 1 ou 2,
**caractérisé en ce que**
l'élément frontal (14a; 14b) de la carte fille (12a; 12b) est relié, via un élément de couplage électriquement conducteur (28), à une section (16) de la carte mère (10) formant une section de la face frontale (22) du dispositif (18).

4. Dispositif selon une des revendications précédentes,
**caractérisé en ce que**
l'élément frontal (14a) de la carte fille (12a) est relié, via au moins un élément de couplage électriquement conducteur (28), à l'élément frontal (14b) d'au moins une autre carte fille (12b), l'au moins une autre carte fille (12b) formant également une section de la face frontale (22) du dispositif (18).

5. Dispositif selon l'une des revendications 3 ou 4,
**caractérisé en ce que**
l'élément de couplage (28) a une forme en U ou une forme en bloc.

6. Dispositif selon la revendication 5,
**caractérisé en ce**
**qu'**un côté de la forme en U ou du bloc est relié à la carte mère (10), un autre côté de la forme en U ou du bloc étant relié à au moins un élément frontal électriquement conducteur (14a; 14b).

7. Dispositif selon l'une des revendications précédentes,
**caractérisé en ce que**
l'au moins une carte fille (12a; 12b) est munie d'au moins un raccordement (26a; 16b; 26c; 26d) pour des signaux d'entrée et/ou de sortie.

8. Dispositif selon l'une des revendications précédentes,
**caractérisé en ce que**
la construction mécanique du dispositif (18) répond aux exigences de la norme IEEE 1101.

9. Dispositif selon l'une des revendications 4 à 8,
**caractérisé en ce que**
la face de la carte fille (12a; 12b), opposée au moyen de couplage (28), venant s'appuyer contre la face frontale (22) du dispositif (18), est reliée à la carte mère (10) grâce à un troisième moyen de fixation (30).

10. Dispositif selon l'une des revendications précédentes,
**caractérisé en ce que**
l'élément frontal (14a; 14b) de l'au moins une carte fille (12a; 12b) présente la largeur normalisée (B) sur toute sa longueur.

11. Dispositif selon l'une des revendications précédentes,
**caractérisé en ce que**
la carte fille (10) est munie de moyens de fixation destinés à une liaison électrique conductrice et mécanique avec un ordinateur central.
